# EUROPEAN PATENT APPLICATION

(11) **EP 2 866 271 A1**
(43) Date of publication of application: **29.04.2015**
(21) Application number: 14157437.6
(22) Date of filing: 03.03.2014
(51) Int. Cl.: H01L 33/50, H01L 33/00, H01L 33/44, H01L 33/38

(54) **Semiconductor light emitting device**

(30) Priority: 28.10.2013 JP 2013223446
(71) Applicant: Kabushiki Kaisha Toshiba, Tokyo 105-8001 (JP)
(72) Inventor: Tomizawa, Hideyuki, Minato-ku, Tokyo 105-8001 (JP); Shimada, Miyoko, Minato-ku, Tokyo 105-8001 (JP); Kojima, Akihiro, Minato-ku, Tokyo 105-8001 (JP); Akimoto, Yosuke, Minato-ku, Tokyo 105-8001 (JP); Shimojuku, Miyuki, Minato-ku, Tokyo 105-8001 (JP); Furuyama, Hideto, Minato-ku, Tokyo 105-8001 (JP); Sugizaki, Yoshiaki, Minato-ku, Tokyo 105-8001 (JP)
(74) Representative: Hoffmann Eitle

(57) **Abstract**

According to one embodiment, the fluorescer layer is provided on the first surface side. The fluorescer layer has a side surface provided at an obtuse angle with respect to the first surface. The fluorescer layer includes a plurality of fluorescers and a binder. The plurality of fluorescers is configured to be excited by light emitted from the light emitting layer to emit light of a wavelength different from a wavelength of the light emitted from the light emitting layer. The binder is configured to combine the plurality of fluorescers in a single body and transmit the light emitted from the light emitting layer and light emitted from the fluorescers.

## Description

### FIELD

Embodiments described herein relate generally to a semiconductor light emitting device.

### BACKGROUND

A semiconductor light emitting device has been proposed in which a chip size fluorescer layer is provided on the light extraction surface (a first surface) of an LED (Light Emitting Diode) chip, and a chip size package including an interconnect unit is provided on the surface (a second surface) of the LED chip on the side opposite to the light extraction surface. In such a semiconductor light emitting device, the light that undergoes total internal reflections at the upper surface and side surfaces of the fluorescer layer undesirably returns to the semiconductor layer side.

### BRIEF DESCRIPTION OF THE DRAWINGS

FIG. 1 is a schematic cross-sectional view of a semiconductor light emitting device of an embodiment;
FIG. 2 is a schematic cross-sectional view of the semiconductor light emitting device of the embodiment;
FIG. 3 is a schematic cross-sectional view of the semiconductor light emitting device of the embodiment;
FIG. 4 is a schematic cross-sectional view of the semiconductor light emitting device of the embodiment;
FIGS. 5A and 5B are schematic cross-sectional views of the semiconductor light emitting device of the embodiment;
FIG. 6 is a schematic cross-sectional view of the semiconductor light emitting device of the embodiment;
FIGS. 7A and 7B are schematic plan views of a fluorescer layer of the semiconductor light emitting device of the embodiment;
FIG. 8A to FIG. 14B are schematic cross-sectional views showing a method for manufacturing the semiconductor light emitting device of the embodiment; and
FIGS. 15A and 15B are schematic views of the semiconductor light emitting device of the embodiment.

### DETAILED DESCRIPTION

According to one embodiment, a semiconductor light emitting device includes a semiconductor layer, a p-side electrode, an n-side electrode, a p-side interconnect unit, an n-side interconnect unit, a resin layer, and a fluorescer layer. The semiconductor layer includes a light emitting layer. The semiconductor layer has a first surface and a second surface opposite to the first surface. The p-side electrode is provided on the semiconductor layer. The n-side electrode is provided on the semiconductor layer. The p-side interconnect unit is provided on the second surface side to be connected to the p-side electrode. The n-side interconnect unit is provided on the second surface side to be connected to the n-side electrode. The resin layer is provided between the p-side interconnect unit and the n-side interconnect unit. The fluorescer layer is provided on the first surface side. The fluorescer layer has a side surface provided at an obtuse angle with respect to the first surface. The fluorescer layer includes a plurality of fluorescers and a binder. The plurality of fluorescers is configured to be excited by light emitted from the light emitting layer to emit light of a wavelength different from a wavelength of the light emitted from the light emitting layer. The binder is configured to combine the plurality of fluorescers in a single body and transmit the light emitted from the light emitting layer and light emitted from the fluorescers.

Embodiments will now be described with reference to the drawings. Similar components in the drawings are marked with like reference numerals.

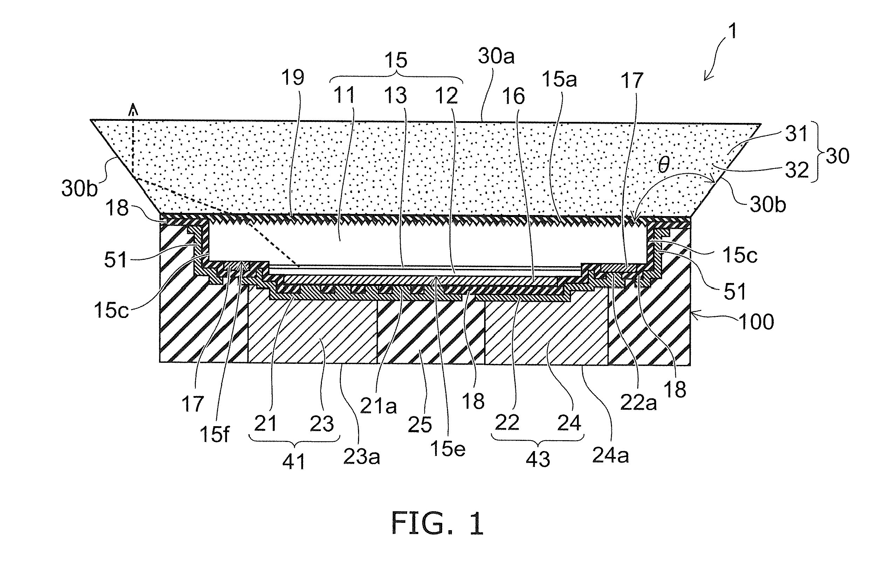

FIG. 1 is a schematic cross-sectional view of a semiconductor light emitting device 1 of a first embodiment.

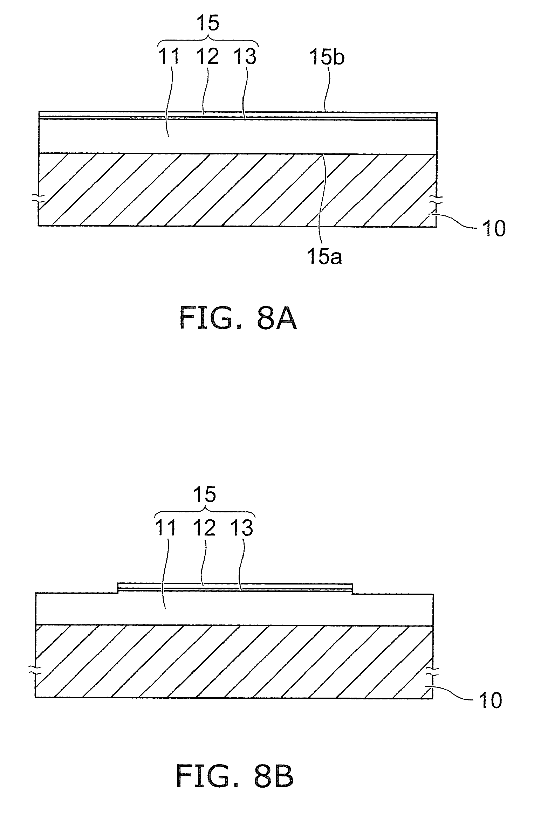

The semiconductor light emitting device 1 includes a semiconductor layer 15 that includes a light emitting layer 13. The semiconductor layer 15 has a first surface 15a, and a second surface 15b (referring to FIG. 8A) on the side opposite to the first surface 15a.

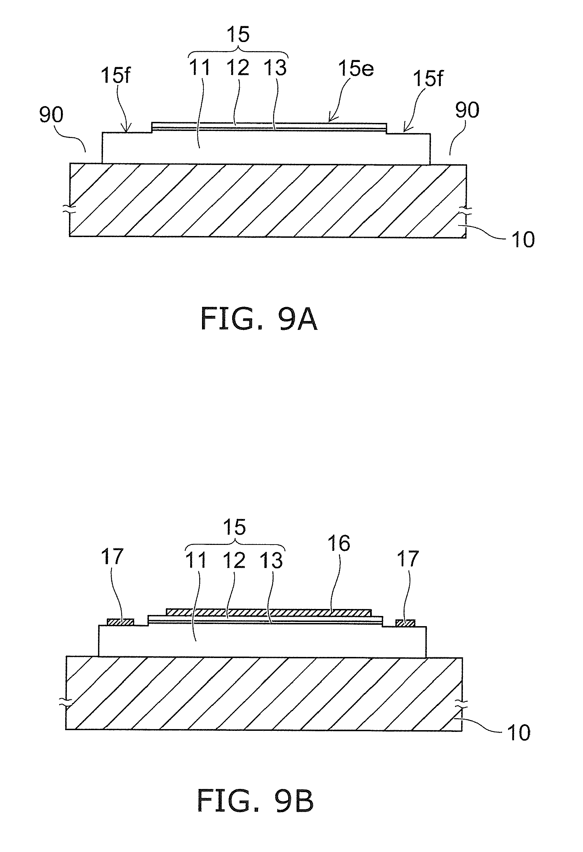

As shown in FIG. 9A, the second surface 15b of the semiconductor layer 15 has a portion (a light emitting region) 15e including the light emitting layer 13, and a portion (a non-light emitting region) 15f not including the light emitting layer 13. The portion 15e including the light emitting layer 13 is the portion of the semiconductor layer 15 in which the light emitting layer 13 is stacked. The portion 15f not including the light emitting layer 13 is the portion of the semiconductor layer 15 in which the light emitting layer 13 is not stacked. The portion 15e including the light emitting layer 13 is the region that has the stacked structure capable of extracting the light emitted by the light emitting layer 13 to the outside.

On the second surface side, a p-side electrode 16 is provided on the portion 15e including the light emitting layer 13; and an n-side electrode 17 is provided on the portion 15f not including the light emitting layer.

The light emitting layer 13 emits light by a current being supplied to the light emitting layer 13 via the p-side electrode 16 and the n-side electrode 17. Then, the light that is radiated from the light emitting layer 13 is emitted outside the semiconductor light emitting device 1 from the first surface 15a side.

As shown in FIG. 1, a support body 100 is provided on the second surface side of the semiconductor layer 15. A light emitting element (an LED chip) that includes the semiconductor layer 15, the p-side electrode 16, and the n-side electrode 17 is supported by the support body 100 provided on the second surface side.

A fluorescer layer 30 is provided on the first surface 15a side of the semiconductor layer 15. The fluorescer layer 30 includes fluorescers 31 having multiple particle configurations. The fluorescers 31 are excited by the light radiated by the light emitting layer 13 to radiate light of a wavelength different from that of the light radiated by the light emitting layer 13.

The multiple fluorescers 31 are combined in a single body by a binder 32. The binder 32 transmits the light radiated by the light emitting layer 13 and the light radiated by the fluorescers 31. Herein, "transmitting" is not limited to the transmittance being 100% and includes the case where a portion of the light is absorbed.

The semiconductor layer 15 includes a first semiconductor layer 11, a second semiconductor layer 12, and the light emitting layer 13. The light emitting layer 13 is provided between the first semiconductor layer 11 and the second semiconductor layer 12. The first semiconductor layer 11 and the second semiconductor layer 12 include, for example, gallium nitride.

The first semiconductor layer 11 includes, for example, a foundation buffer layer and an n-type GaN layer. The second semiconductor layer 12 includes, for example, a p-type GaN layer. The light emitting layer 13 includes a material that emits blue light, violet light, bluish-violet light, ultraviolet light, etc. The light emission peak wavelength of the light emitting layer 13 is, for example, 430 to 470 nm.

The second surface of the semiconductor layer 15 is patterned into an uneven configuration. The protruding portion of the uneven configuration is the portion 15e including the light emitting layer 13; and the recessed portion of the uneven configuration is the portion 15f not including the light emitting layer 13. The surface of the portion 15e including the light emitting layer 13 is the surface of the second semiconductor layer 12; and the p-side electrode 16 is provided on the surface of the second semiconductor layer 12. The surface of the portion 15f not including the light emitting layer 13 is the surface of the first semiconductor layer 11; and the n-side electrode 17 is provided on the surface of the first semiconductor layer 11.

The p-side electrode 16 contacts the surface of the second semiconductor layer 12; and the n-side electrode 17 contacts the surface of the first semiconductor layer 11.

At the second surface of the semiconductor layer 15, the surface area of the portion 15e including the light emitting layer 13 is greater than the surface area of the portion 15f not including the light emitting layer 13. Also, the surface area of the p-side electrode 16 provided on the surface of the portion 15e including the light emitting layer 13 is greater than the surface area of the n-side electrode 17 provided on the surface of the portion 15f not including the light emitting layer 13. Thereby, a wide light emitting surface is obtained; and the light output can be high.

As shown in FIG. 1, the second surface of the semiconductor layer 15, the p-side electrode 16, and the n-side electrode 17 are covered with an insulating film 18. The insulating film 18 is, for example, an inorganic insulating film such as a silicon oxide film, etc. The insulating film 18 is provided also on the side surface of the light emitting layer 13 and the side surface of the second semiconductor layer 12 to cover these side surfaces.

The insulating film 18 is provided also on a side surface 15c of the semiconductor layer 15 (the side surface of the first semiconductor layer 11) continuing from the first surface 15a to cover the side surface 15c.

The insulating film 18 is provided also in the region around the side surface 15c of the semiconductor layer 15. The insulating film 18 that is provided in the region around the side surface 15c at the first surface 15a side extends away from the side surface 15c.

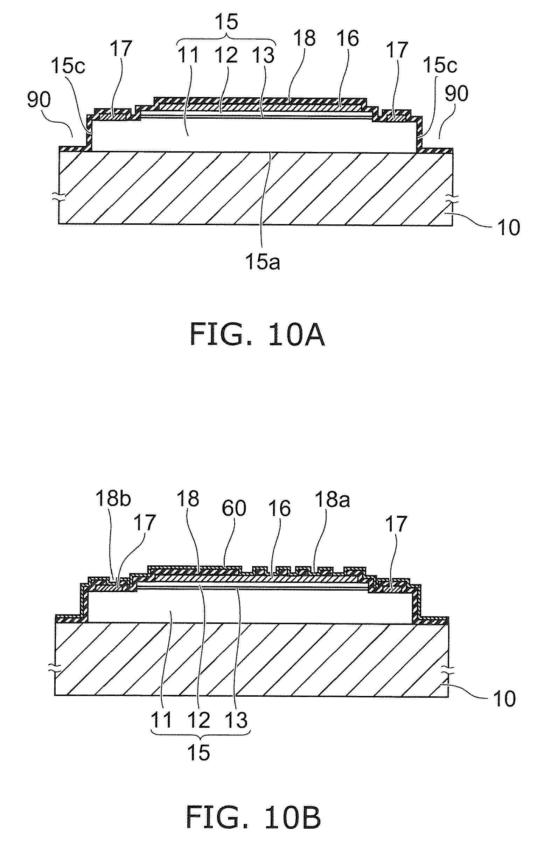

A p-side interconnect layer 21 and an n-side interconnect layer 22 are provided on the insulating film 18 to be separated from each other. As shown in FIG. 10B, multiple first openings 18a that communicate with the p-side electrode 16 and a second opening 18b that communicates with the n-side electrode 17 are made in the insulating film 18. The first openings 18a may be one large opening.

The p-side interconnect layer 21 is provided on the insulating film 18 and in the interiors of the first openings 18a. The p-side interconnect layer 21 is electrically connected to the p-side electrode 16 by vias 21a provided inside the first openings 18a.

The n-side interconnect layer 22 is provided on the insulating film 18 and in the interior of the second opening 18b. The n-side interconnect layer 22 is electrically connected to the n-side electrode 17 by a via 22a provided inside the second opening 18b.

The p-side interconnect layer 21 and the n-side interconnect layer 22 are provided on the insulating film 18 to occupy the greater part of the region on the second surface side. The p-side interconnect layer 21 is connected to the p-side electrode 16 by the multiple vias 21a.

A metal film 51 covers the side surface 15c of the semiconductor layer 15 with the insulating film 18 interposed. The metal film 51 does not contact the side surface 15c and is not electrically connected to the semiconductor layer 15. The metal film 51 is separated from the p-side interconnect layer 21 and the n-side interconnect layer 22. The metal film 51 is reflective to the light radiated by the light emitting layer 13 and the light radiated by the fluorescers 31.

The metal film 51, the p-side interconnect layer 21, and the n-side interconnect layer 22 include copper films formed simultaneously by, for example, plating on a common foundation metal film.

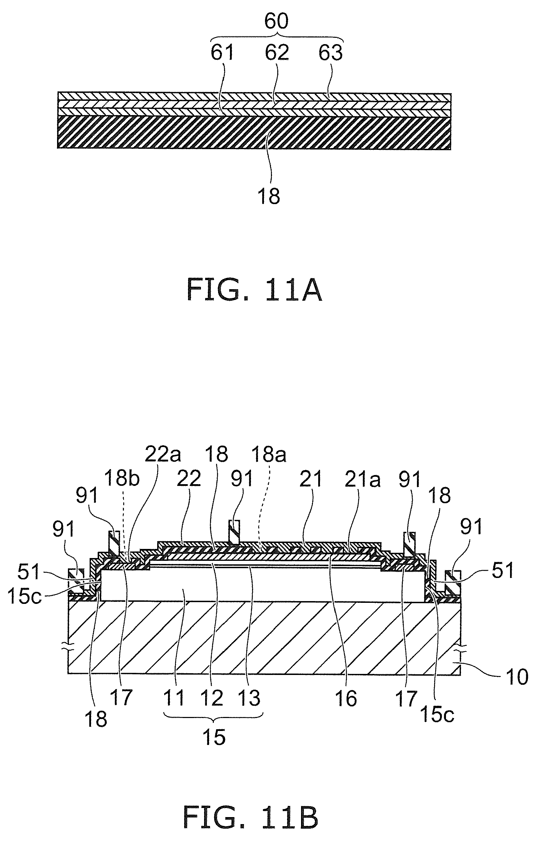

FIG. 11A is a schematic cross-sectional view of a foundation metal film 60.

For example, the copper films of the metal film 51, the p-side interconnect layer 21, and the n-side interconnect layer 22 are formed by plating on the foundation metal film 60 formed on the insulating film 18. Or, the metal film 51, the p-side interconnect layer 21, and the n-side interconnect layer 22 include the foundation metal film 60.

The foundation metal film 60 includes an aluminum (Al) film 61, a titanium (Ti) film 62, and a copper (Cu) film 63 stacked in order from the insulating film 18 side.

The aluminum film 61 functions as a reflective film; and the copper film 63 functions as a seed layer of the plating. The titanium film 62, which has excellent wettability for both aluminum and copper, functions as an adhesion layer.

For example, the thickness of the foundation metal film 60 is about 1 µm; and the thicknesses of the metal film 51, the p-side interconnect layer 21, and the n-side interconnect layer 22 are several µm.

Also, the metal film 51 may be a film made of the foundation metal film 60 without forming the plating film (the copper film) on the foundation metal film 60 in the region around the side surface 15c of the semiconductor layer 15. The metal film 51 has high reflectance for the light radiated by the light emitting layer 13 and the light radiated by the fluorescers 31 by the metal film 51 including at least the aluminum film 61.

Because the aluminum film 61 also remains under the p-side interconnect layer 21 and the n-side interconnect layer 22, the aluminum film (the reflective film) 61 is formed over the greater part of the region on the second surface side. Thereby, the amount of the light traveling toward the fluorescer layer 30 side can be increased.

A p-type metal pillar 23 is provided on the surface of the p-side interconnect layer 21 on the side opposite to the semiconductor layer 15. A p-side interconnect unit 41 is formed of the p-side interconnect layer 21 and the p-type metal pillar 23.

An n-side metal pillar 24 is provided on the surface of the n-side interconnect layer 22 on the side opposite to the semiconductor layer 15. An n-side interconnect unit 43 is formed of the n-side interconnect layer 22 and the n-side metal pillar 24.

A resin layer 25 is provided as an insulating film between the p-side interconnect unit 41 and the n-side interconnect unit 43. The resin layer 25 is provided between the p-type metal pillar 23 and the n-side metal pillar 24 to contact the side surface of the p-type metal pillar 23 and the side surface of the n-side metal pillar 24. In other words, the resin layer 25 is filled between the p-type metal pillar 23 and the n-side metal pillar 24.

Also, the resin layer 25 is provided between the p-side interconnect layer 21 and the n-side interconnect layer 22, between the p-side interconnect layer 21 and the metal film 51, and between the n-side interconnect layer 22 and the metal film 51.

The resin layer 25 is provided around the p-type metal pillar 23 and around the n-side metal pillar 24 to cover the side surface of the p-type metal pillar 23 and the side surface of the n-side metal pillar 24.

The resin layer 25 is provided also in the region around the side surface 15c of the semiconductor layer 15 to cover the metal film 51.

The end portion (the surface) of the p-type metal pillar 23 on the side opposite to the p-side interconnect layer 21 is exposed from the resin layer 25 to function as a p-side external terminal 23a that is connectable to an external circuit such as a mounting substrate, etc. The end portion (the surface) of the n-side metal pillar 24 on the side opposite to the n-side interconnect layer 22 is exposed from the resin layer 25 to function as an n-side external terminal 24a that is connectable to the external circuit such as the mounting substrate, etc. The p-side external terminal 23a and the n-side external terminal 24a are bonded to a land pattern of the mounting substrate via, for example, solder or a bonding agent that is conductive.

The p-side external terminal 23a and the n-side external terminal 24a are formed to be arranged in the same surface (in FIG. 1, the lower surface) of the resin layer 25 to be separated from each other. The spacing between the p-side external terminal 23a and the n-side external terminal 24a is wider than the spacing between the p-side interconnect layer 21 and the n-side interconnect layer 22 on the insulating film 18. The spacing between the p-side external terminal 23a and the n-side external terminal 24a is set to be larger than the spread of the solder in the mounting. Thereby, shorts between the p-side external terminal 23a and the n-side external terminal 24a via the solder can be prevented.

Conversely, the spacing between the p-side interconnect layer 21 and the n-side interconnect layer 22 can be reduced to the process limits. Therefore, the surface area of the p-side interconnect layer 21 and the contact surface area between the p-side interconnect layer 21 and the p-type metal pillar 23 can be increased. Thereby, dissipation of the heat of the light emitting layer 13 can be promoted.

The surface area of the p-side interconnect layer 21 contacting the p-side electrode 16 by the multiple vias 21a is greater than the surface area of the n-side interconnect layer 22 contacting the n-side electrode 17 by the via 22a. Thereby, the distribution of the current flowing in the light emitting layer 13 can be made uniform.

The surface area of the n-side interconnect layer 22 on the insulating film 18 can be greater than the surface area of the n-side electrode 17. Then, the surface area of the n-side metal pillar 24 provided on the n-side interconnect layer 22 (the surface area of the n-side external terminal 24a) can be greater than the surface area of the n-side electrode 17. Thereby, it is possible to reduce the surface area of the n-side electrode 17 while ensuring a surface area of the n-side external terminal 24a that is sufficient to provide mounting having high reliability. In other words, it is possible to increase the light output by reducing the surface area of the portion (the non-light emitting region) 15f of the semiconductor layer 15 not including the light emitting layer 13 and by increasing the surface area of the portion (the light emitting region) 15e including the light emitting layer 13.

The first semiconductor layer 11 is electrically connected to the n-side metal pillar 24 via the n-side electrode 17 and the n-side interconnect layer 22. The second semiconductor layer 12 is electrically connected to the p-type metal pillar 23 via the p-side electrode 16 and the p-side interconnect layer 21.

The thickness (the thickness in the direction connecting the p-side interconnect layer 21 and the p-side external terminal 23a) of the p-type metal pillar 23 is thicker than the thickness of the p-side interconnect layer 21. The thickness (the thickness in the direction connecting the n-side interconnect layer 22 and the n-side external terminal 24a) of the n-side metal pillar 24 is thicker than the thickness of the n-side interconnect layer 22. The thicknesses of the p-type metal pillar 23, the n-side metal pillar 24, and the resin layer 25 are thicker than the semiconductor layer 15.

The aspect ratio (the ratio of the thickness to the planar size) may be 1, more than 1, or less than 1 for the metal pillars 23 and 24. In other words, the metal pillars 23 and 24 may be thicker or thinner than their planar sizes.

The thickness of the support body 100 that includes the p-side interconnect layer 21, the n-side interconnect layer 22, the p-type metal pillar 23, the n-side metal pillar 24, and the resin layer 25 is thicker than the thickness of the light emitting element (the LED chip) that includes the semiconductor layer 15, the p-side electrode 16, and the n-side electrode 17.

As described below, the semiconductor layer 15 is formed by epitaxial growth on the substrate. The substrate is removed after forming the support body 100; and the semiconductor layer 15 does not include a substrate on the first surface 15a side. The semiconductor layer 15 is supported not by a substrate that is rigid and has a plate configuration but by the support body 100 which is a compound body including the metal pillars 23 and 24 and the resin layer 25.

For example, copper, gold, nickel, silver, etc., may be used as the material of the p-side interconnect unit 41 and the n-side interconnect unit 43. Among these, good thermal conductivity, high migration resistance, and better adhesion with insulating materials can be obtained when copper is used.

The resin layer 25 reinforces the p-type metal pillar 23 and the n-side metal pillar 24. It is desirable for the resin layer 25 to have a coefficient of thermal expansion near to or the same as that of the mounting substrate. Such a resin layer 25 may include, for example, a resin including mainly an epoxy resin, a resin including mainly a silicone resin, or a resin including mainly a fluorocarbon resin.

The resin layer 25 is light-shielding to the light emitted by the light emitting layer 13 by including a light-shielding material (a light absorbing agent, a light reflecting agent, a light scattering agent, etc.) in the resin that is used as the base of the resin layer 25. Thereby, light leakage from the side surface and mounting surface side of the support body 100 can be suppressed.

Stress that is caused by the solder, etc., that bonds the p-side external terminal 23a and the n-side external terminal 24a to the lands of the mounting substrate is applied to the semiconductor layer 15 by the thermal cycles in the mounting of the semiconductor light emitting device. The stress is absorbed and relaxed by the p-type metal pillar 23, the n-side metal pillar 24, and the resin layer 25. In particular, the stress relieving effect can be increased by using the resin layer 25 that is more flexible than the semiconductor layer 15 as a portion of the support body 100.

The metal film 51 is separated from the p-side interconnect unit 41 and the n-side interconnect unit 43. Therefore, the stress that is applied to the p-type metal pillar 23 and the n-side metal pillar 24 in the mounting is not transferred to the metal film 51. Accordingly, peeling of the metal film 51 can be suppressed. Also, the stress that is applied on the side surface 15c side of the semiconductor layer 15 can be suppressed.

As described below, the substrate that is used to form the semiconductor layer 15 is removed from the semiconductor layer 15. Thereby, the semiconductor light emitting device 1 is thinner. Further, a micro unevenness can be formed in the first surface 15a of the semiconductor layer 15 by removing the substrate; and the light extraction efficiency can be increased.

For example, the micro unevenness is formed by performing wet etching of the first surface 15a using an alkaline solution. Thereby, the total internal reflection component at the first surface 15a can be reduced; and the light extraction efficiency can be increased.

After the substrate is removed, the fluorescer layer 30 is formed on the first surface 15a with an insulating film 19 interposed. The insulating film 19 functions as an adhesion layer that increases the adhesion between the semiconductor layer 15 and the fluorescer layer 30 and is, for example, a silicon oxide film or a silicon nitride film.

The fluorescer layer 30 has a structure in which the fluorescers 31 having multiple particle configurations are dispersed in the binder 32. The binder 32 may include, for example, a silicone resin.

The fluorescer layer 30 also is formed on the region around the side surface 15c of the semiconductor layer 15. Accordingly, the planar size of the fluorescer layer 30 is larger than the planar size of the semiconductor layer 15. The fluorescer layer 30 is provided on the insulating film 18 and the insulating film 19 in the region around the side surface 15c of the semiconductor layer 15.

The fluorescer layer 30 is limited to being provided on the first surface 15a of the semiconductor layer 15 and on the region around the side surface 15c of the semiconductor layer 15 and is not formed to extend around to the second surface side of the semiconductor layer 15, around the metal pillars 23 and 24, or around to the side surface of the support body 100.

In other words, the semiconductor light emitting device 1 of the embodiment is an extremely small semiconductor light emitting device having a chip size package structure. Therefore, the degrees of freedom of, for example, light fixture designs are higher in applications for light fixtures for illumination, etc.

Also, the fluorescer layer 30 is not formed unnecessarily on the mounting surface side where the light is not extracted to the outside; and the cost can be reduced. Further, the heat of the light emitting layer 13 can be dissipated to the mounting substrate side via the p-side interconnect layer 21 and the n-side interconnect layer 22 that are provided over the second surface side even without a substrate on the first surface 15a side; and the heat dissipation is excellent even though the package is small.

In general flip chip mounting, the LED chip is mounted to the mounting substrate via bumps, etc.; and subsequently, the fluorescer layer is formed to cover the entire chip. Or, a resin is under-filled between the bumps.

Conversely, according to the embodiment, the resin layer 25, which is different from the fluorescer layer 30, is provided around the p-type metal pillar 23 and around the n-side metal pillar 24 in the state prior to mounting and can provide characteristics suited to stress relief on the mounting surface side. Also, because the resin layer 25 is provided already on the mounting surface side, the under-fill after the mounting is unnecessary.

The fluorescer layer 30 that is designed with priority on the light extraction efficiency, color conversion efficiency, light distribution characteristics, etc., is provided on the first surface 15a side; and the resin layer 25 that is designed with priority on the stress relief in the mounting and characteristics as a support body to replace the substrate is provided on the mounting surface side. For example, the resin layer 25 has a structure in which a filler such as silica particles, etc., is filled at a high density in the resin that is used as the base; and the hardness is adjusted to be appropriate as a support body.

The light radiated from the light emitting layer 13 to the first surface 15a side is incident on the fluorescer layer 30; a portion of the light excites the fluorescers 31; and, for example, white light is obtained as mixed light of the light of the light emitting layer 13 and the light of the fluorescers 31.

Here, in the case where there is a substrate on the first surface 15a, light may leak to the outside from the side surface of the substrate without being incident on the fluorescer layer 30. In other words, light of the light emitting layer 13 that has a strong tint leaks from the side surface of the substrate which may cause color breakup and uneven color such as a phenomenon in which a ring of blue light is viewed at the outer edge side when the fluorescer layer 30 is viewed from the upper surface, etc.

Conversely, according to the embodiment, because there is no substrate between the first surface 15a and the fluorescer layer 30, color breakup and uneven color due to the light of the light emitting layer 13 that has a strong tint leaking from the substrate side surface can be prevented.

Further, according to the embodiment, the metal film 51 is provided on the side surface 15c of the semiconductor layer 15 with the insulating film 18 interposed. The light that is traveling from the light emitting layer 13 toward the side surface 15c of the semiconductor layer 15 is reflected by the metal film 51 and does not leak to the outside. Therefore, color breakup and uneven color due to the light leakage from the side surface side of the semiconductor light emitting device can be prevented in addition to the feature of having no substrate on the first surface 15a side.

The insulating film 18 that is provided between the metal film 51 and the side surface 15c of the semiconductor layer 15 prevents the diffusion of the metal included in the metal film 51 into the semiconductor layer 15. Thereby, for example, metal contamination of the GaN of the semiconductor layer 15 can be prevented; and the degradation of the semiconductor layer 15 can be prevented.

The insulating film 18 and the insulating film 19 are, for example, inorganic insulating films such as a silicon oxide film, a silicon nitride film, etc. In other words, the first surface 15a and the second surface of the semiconductor layer 15, the side surface 15c of the first semiconductor layer 11, the side surface of the second semiconductor layer 12, and the side surface of the light emitting layer 13 are covered with the inorganic insulating films. The inorganic insulating films are provided around the semiconductor layer 15 to block the semiconductor layer 15 from metal, moisture, etc.

According to the embodiment, a side surface 30b of the fluorescer layer 30 is tilted with respect to the first surface 15a of the semiconductor layer 15 and with respect to an upper surface 30a of the fluorescer layer 30.

The side surface 30b of the fluorescer layer 30 is provided at an obtuse angle with respect to the first surface 15a. In other words, an angle θ between the first surface 15a and the side surface 30b of the fluorescer layer 30 is greater than 90°.

The planar size of the fluorescer layer 30 gradually increases from the first surface 15a side toward the upper surface 30a side. The side surface 30b of the fluorescer layer 30 is positioned outside the side surface of the support body 100 (the side surface of the resin layer 25) in the surface direction of the first surface 15a.

An unevenness having a size and density that increase the light extraction efficiency by the light-scattering effect is deliberately not formed in the side surface 30b of the fluorescer layer 30; and the side surface 30b of the fluorescer layer 30 is a substantially flat surface.

The side surface 30b of the fluorescer layer 30 is tilted at an obtuse angle with respect to the first surface 15a. Therefore, as schematically illustrated by the broken-line arrow in FIG. 1, the incident angle on the side surface 30b of the light (the light radiated by the light emitting layer 13 and the light radiated by the fluorescers 31) traveling toward the side surface 30b of the fluorescer layer 30 becomes large; and the component of the total internal reflection toward the upper surface 30a side increases at the interface between the side surface 30b and the air layer.

Therefore, the light amount that is extracted from the upper surface 30a of the fluorescer layer 30 can be increased; the light that returns to the semiconductor layer 15 side decreases; and the absorption loss of the light due to the semiconductor layer 15, the metals, the insulating films, and the resin materials can be suppressed. Accordingly, according to the embodiment, a highly efficient and highly reliable semiconductor light emitting device that has an extremely small chip size package structure can be provided.

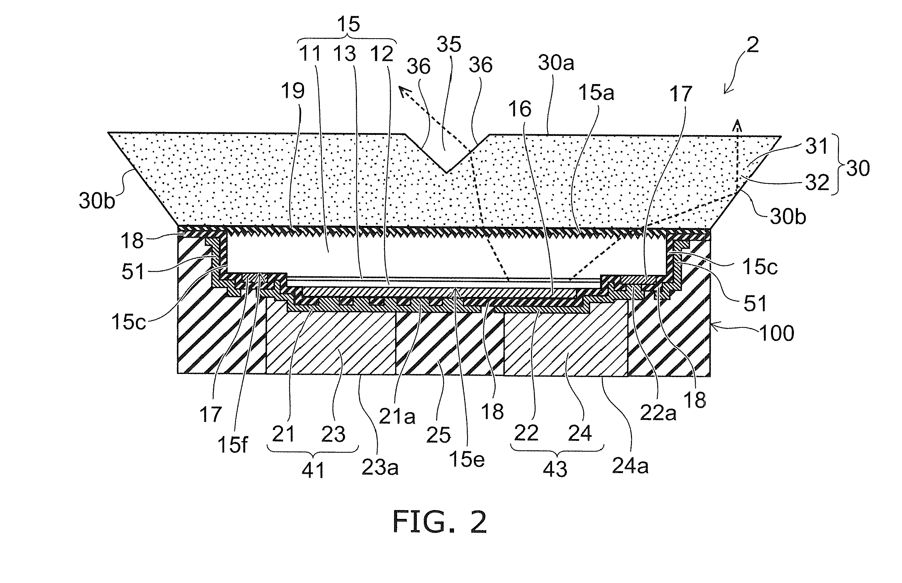

FIG. 2 is a schematic cross-sectional view of a semiconductor light emitting device 2 of a second embodiment.

In addition to the configuration of the semiconductor light emitting device 1 of the first embodiment, a trench 35 having a cross-sectional V-shaped configuration is made in the upper surface 30a of the fluorescer layer 30 in the semiconductor light emitting device 2 of the second embodiment. Otherwise, the configuration is the same as that of the first embodiment.

A side surface (an inner wall surface) 36 of the trench 35 is tilted with respect to the upper surface 30a of the fluorescer layer 30 and the first surface 15a of the semiconductor layer 15.

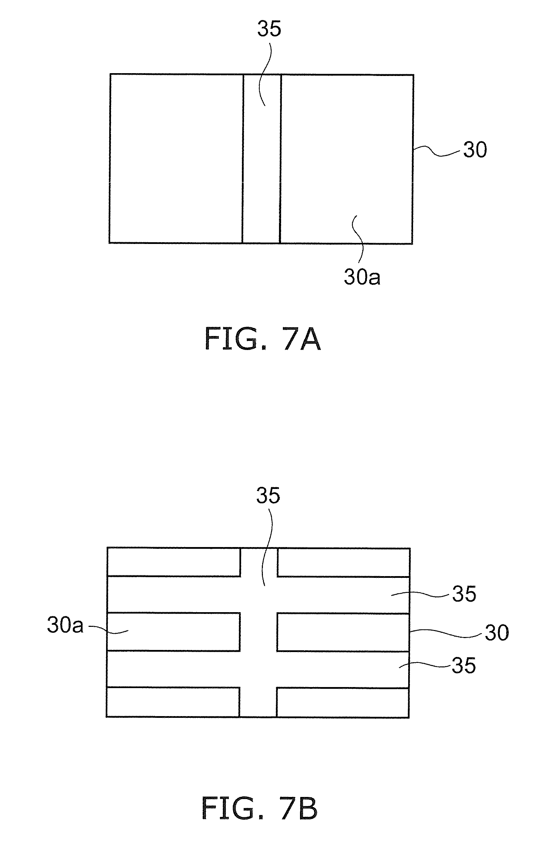

FIGS. 7A and 7B are schematic top views of the fluorescer layer 30 in which the trench 35 is made.

As shown in FIG. 7A, the trench 35 is made in a line configuration. The trench 35 extends in a direction along the outline of the upper surface 30a of the fluorescer layer 30. Or, the trench 35 may extend along a direction tilted with respect to the outline of the upper surface 30a of the fluorescer layer 30.

As shown in FIG. 7B, the trench 35 may be made in multiple line configurations in the upper surface 30a of the fluorescer layer 30.

The depth of the trench 35 is greater than the size of the fluorescers 31 included in the fluorescer layer 30. Herein, the size of the fluorescers 31 is the average particle diameter of the multiple fluorescers 31, or the peak particle diameter or maximum particle diameter of the particle diameter distribution. The depth of the trench 35 is, for example, several tens of µm.

A trench in which the bottom portion has curvature where the two side surfaces (the tilted surfaces) 36 of the trench 35 are linked to each other also is included in the trench having the cross-sectional V-shaped configuration of the specification.

According to the second embodiment as schematically illustrated by the broken-line arrow in FIG. 2, the light component that has a large incident angle with respect to the upper surface 30a of the fluorescer layer 30 and would undergo a total internal reflection at the upper surface 30a also can be extracted outside the fluorescer layer 30 from the side surfaces (the tilted surfaces) 36 of the V-shaped trench 35.

Therefore, the light that is traveling toward the upper surface 30a can be efficiently extracted to the outside by the V-shaped trench 35 while increasing the light component toward the upper surface 30a side by the total internal reflection at the side surface 30b of the fluorescer layer 30.

It is possible to adjust the spread angle (the light distribution characteristics) of the light extracted from the fluorescer layer 30 by adjusting the position, number, depth, and tilt angle of the side surfaces (the tilted surfaces) 36 for the V-shaped trench 35.

Accordingly, the control of the light distribution characteristics is easy despite being an extremely small semiconductor light emitting device having a chip size package.

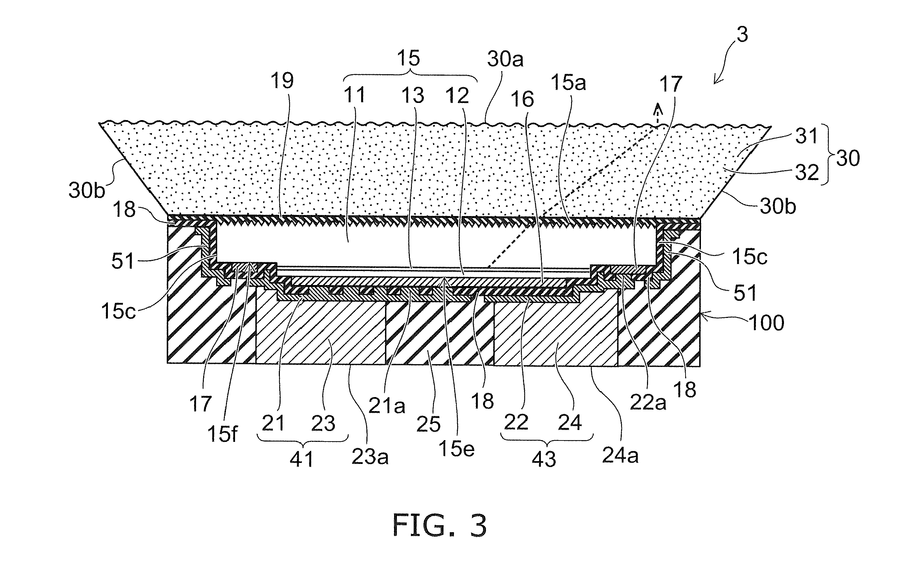

FIG. 3 is a schematic cross-sectional view of a semiconductor light emitting device 3 of a third embodiment.

In addition to the configuration of the semiconductor light emitting device 1 of the first embodiment, an unevenness is formed in the upper surface 30a of the fluorescer layer 30 of the semiconductor light emitting device 3 of the third embodiment. Otherwise, the configuration is the same as that of the first embodiment.

By forming the unevenness in the upper surface 30a of the fluorescer layer 30, the light extraction efficiency from the upper surface 30a can be increased by reducing the total internal reflection component at the upper surface 30a by the light-scattering effect.

For example, the unevenness may be formed in the upper surface 30a of the fluorescer layer 30 by etching and/or polishing.

Although the side surface 30b of the fluorescer layer 30 may become slightly rough due to the dicing, the surface roughness of the side surface 30b is low compared to the upper surface 30a in which the unevenness is deliberately formed to increase the light extraction efficiency by the scattering effect. The side surface 30b of the fluorescer layer 30 is flatter than the upper surface 30a; and it is favorable for the side surface 30b to be a substantially flat surface.

According to the third embodiment, the light that is traveling toward the upper surface 30a can be efficiently extracted to the outside by the scattering effect at the unevenness while increasing the light component toward the upper surface 30a side by the total internal reflection at the side surface 30b of the fluorescer layer 30.

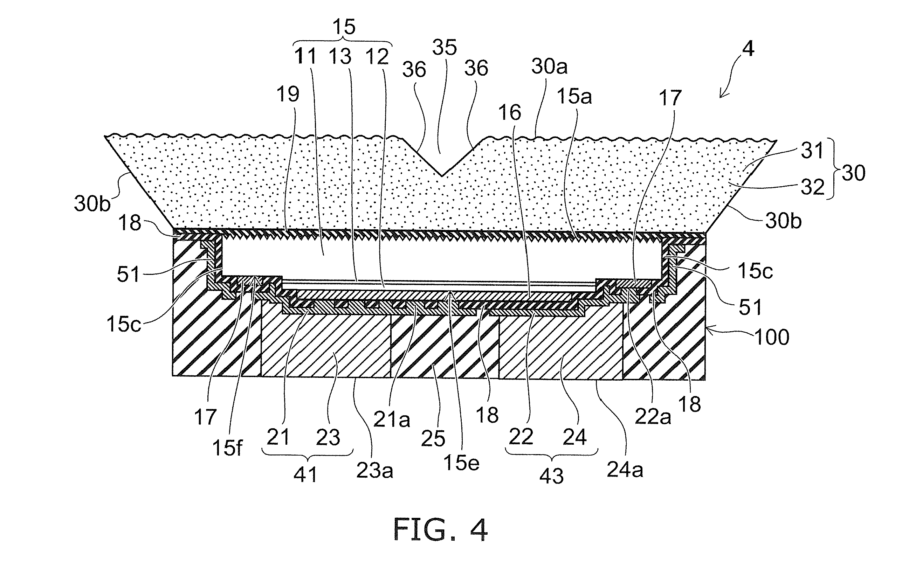

FIG. 4 is a schematic cross-sectional view of a semiconductor light emitting device 4 of a fourth embodiment.

The semiconductor light emitting device 4 of the fourth embodiment has a structure in which the second embodiment and the third embodiment are combined.

In other words, the V-shaped trench 35 is made in a line configuration in the upper surface 30a of the fluorescer layer 30; and an unevenness is formed in a region of the upper surface 30a other than the region of the upper surface 30a where the V-shaped trench 35 is made. The depth of the recess and the height of the protrusion of the unevenness are less than the depth of the V-shaped trench 35.

Accordingly, according to the fourth embodiment, the light that is traveling toward the upper surface 30a can be efficiently extracted to the outside by the V-shaped trench 35 and the unevenness while increasing the light component toward the upper surface 30a side by the total internal reflection at the side surface 30b of the fluorescer layer 30.

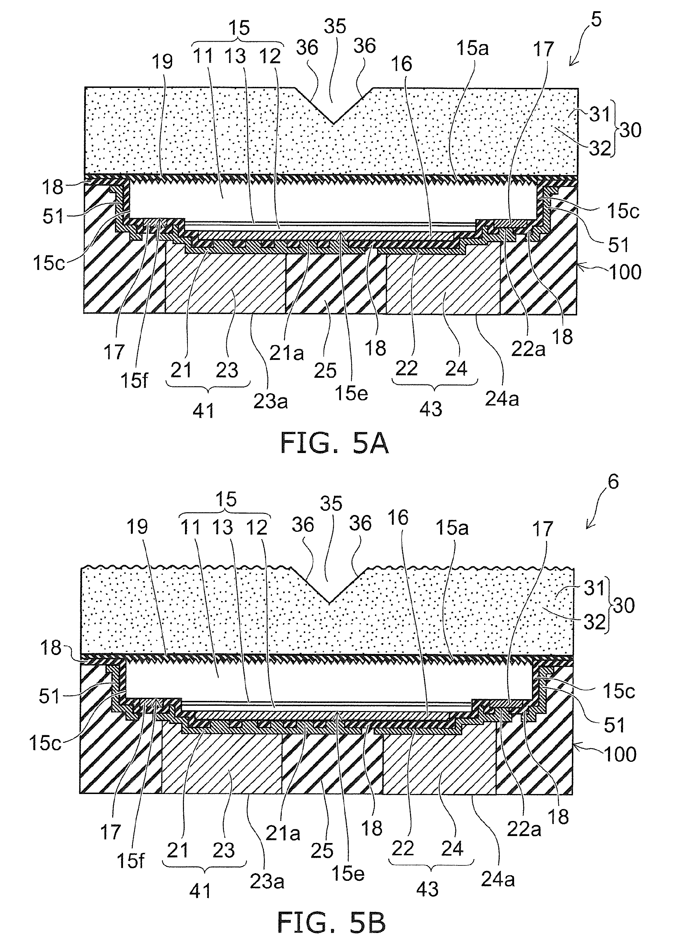

FIG. 5A is a schematic cross-sectional view of a semiconductor light emitting device 5 of a fifth embodiment.

In the semiconductor light emitting device 5 of the fifth embodiment, similarly to the semiconductor light emitting device 2 of the second embodiment, the V-shaped trench 35 is made in the upper surface 30a of the fluorescer layer 30. The side surface of the fluorescer layer 30 is different from that of the second embodiment in that the side surface of the fluorescer layer 30 is not tilted. The side surface of the fluorescer layer 30 is aligned with the side surface of the support body 100 (the side surface of the resin layer 25). Otherwise, the configuration is the same as that of the second embodiment.

According to the fifth embodiment, the light component that has a large incident angle with respect to the upper surface 30a of the fluorescer layer 30 and would undergo a total internal reflection at the upper surface 30a also can be extracted outside the fluorescer layer 30 from the side surfaces (the tilted surfaces) 36 of the V-shaped trench 35.

Also, it is possible to adjust the spread angle (the light distribution characteristics) of the light extracted from the fluorescer layer 30 by adjusting the position, number, depth, and tilt angle of the side surfaces (the tilted surfaces) 36 for the V-shaped trench 35.

Accordingly, the control of the light distribution characteristics is easy despite being an extremely small semiconductor light emitting device having a chip size package.

FIG. 5B is a schematic cross-sectional view of a semiconductor light emitting device 6 of a sixth embodiment.

In addition to the configuration of the semiconductor light emitting device 5 of the fifth embodiment, an unevenness is formed in the upper surface 30a of the fluorescer layer 30 according to the semiconductor light emitting device 6 of the sixth embodiment.

In other words, the V-shaped trench 35 is made in a line configuration in the upper surface 30a of the fluorescer layer 30; and an unevenness is formed in a region of the upper surface 30a other than the region of the upper surface 30a where the V-shaped trench 35 is made. The depth of the recess and the height of the protrusion of the unevenness are less than the depth of the V-shaped trench 35.

Accordingly, according to the sixth embodiment, the light can be efficiently extracted to the outside from the upper surface 30a of the fluorescer layer 30 by the V-shaped trench 35 and the unevenness.

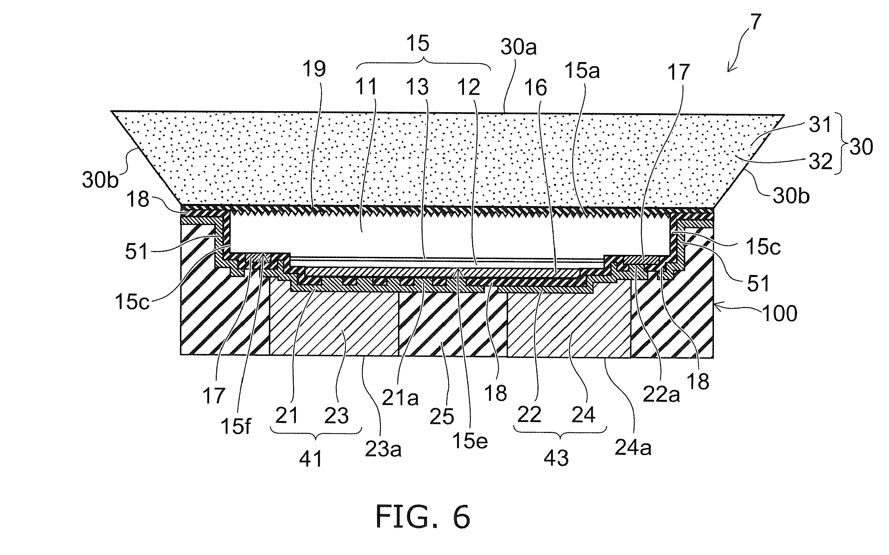

FIG. 6 is a schematic cross-sectional view of a semiconductor light emitting device 7 of a seventh embodiment.

Although the fluorescer layer 30 of the semiconductor light emitting device 7 of the seventh embodiment has the configuration of the fluorescer layer 30 shown in FIG. 1, the fluorescer layer 30 of one selected from FIG. 1, FIG. 2, FIG. 3, FIG. 4, FIG. 5A, and FIG. 5B is applicable as the fluorescer layer 30 of the semiconductor light emitting device 7.

According to the semiconductor light emitting device 7 of the seventh embodiment, the metal film 51 in the region around the side surface 15c of the semiconductor layer 15 extends toward the outer side of the semiconductor light emitting device 7. In other words, the metal film 51 is provided in the region around the side surface 15c of the semiconductor layer 15 to oppose the fluorescer layer 30 that juts from the first surface 15a.

Therefore, the light that is radiated by the fluorescers 31 in the end portion region of the semiconductor light emitting device 7 to travel toward the support body 100 side can be returned toward the fluorescer layer 30 side by being reflected by the metal film 51.

Accordingly, the light extraction efficiency from the fluorescer layer 30 side can be increased by preventing the loss due to the light radiated by the fluorescers 31 being absorbed by the resin layer 25 in the end portion region of the semiconductor light emitting device 7.

The insulating films 18 and 19 that are provided between the metal film 51 and the fluorescer layer 30 increase the adhesion between the metal film 51 and the resin component of the fluorescer layer 30.

A method for manufacturing the semiconductor light emitting device of the embodiment will now be described with reference to FIG. 8A to FIG. 14B.

As shown in FIG. 8A, for example, the first semiconductor layer 11, the light emitting layer 13, and the second semiconductor layer 12 are epitaxially grown in order on the major surface of a substrate 10 by MOCVD (metal organic chemical vapor deposition).

The surface of the semiconductor layer 15 on the substrate 10 side is the first surface 15a; and the surface of the semiconductor layer 15 on the side opposite to the substrate 10 is the second surface 15b.

The substrate 10 is, for example, a silicon substrate. Or, the substrate 10 may be a sapphire substrate. The semiconductor layer 15 is, for example, a nitride semiconductor layer including gallium nitride (GaN).

The first semiconductor layer 11 includes, for example, a buffer layer provided on the major surface of the substrate 10, and an n-type GaN layer provided on the buffer layer. The second semiconductor layer 12 includes, for example, a p-type AlGaN layer provided on the light emitting layer 13, and a p-type GaN layer provided on the p-type AlGaN layer. The light emitting layer 13 has, for example, a MQW (Multiple Quantum Well) structure.

FIG. 8B shows the state in which the second semiconductor layer 12 and the light emitting layer 13 are selectively removed. For example, the first semiconductor layer 11 is exposed by selectively etching the second semiconductor layer 12 and the light emitting layer 13 by RIE (Reactive Ion Etching).

Then, as shown in FIG. 9A, a trench 90 is made by selectively removing the first semiconductor layer 11. The semiconductor layer 15 is divided into a plurality on the major surface of the substrate 10 by the trench 90. The trench 90 is made in, for example, a lattice pattern on the substrate 10 having a wafer configuration.

The trench 90 pierces the semiconductor layer 15 to reach the substrate 10. According to the etching conditions, there are cases where the major surface of the substrate 10 also is etched slightly such that the bottom surface of the trench 90 recedes to be lower than the interface between the substrate 10 and the semiconductor layer 15. The trench 90 may be made after forming the p-side electrode 16 and the n-side electrode 17.

As shown in FIG. 9B, the p-side electrode 16 is formed on the surface of the second semiconductor layer 12. The n-side electrode 17 is formed on the surface of the first semiconductor layer 11 in the region where the second semiconductor layer 12 and the light emitting layer 13 are selectively removed.

The p-side electrode 16 that is formed in the region where the light emitting layer 13 is stacked includes a reflective film that reflects the light radiated by the light emitting layer 13. For example, the p-side electrode 16 includes silver, a silver alloy, aluminum, an aluminum alloy, etc. Also, the p-side electrode 16 includes a metal protective film (a barrier metal) to prevent sulfidization and oxidization of the reflective film.

Then, as shown in FIG. 10A, the insulating film 18 is formed to cover the structural body provided on the substrate 10. The insulating film 18 covers the second surface of the semiconductor layer 15, the p-side electrode 16, and the n-side electrode 17. Also, the insulating film 18 covers the side surface 15c continuing from the first surface 15a of the semiconductor layer 15. The insulating film 18 also is formed on the surface of the substrate 10 at the bottom surface of the trench 90.

The insulating film 18 is a silicon oxide film or a silicon nitride film formed by, for example, CVD (Chemical Vapor Deposition). As shown in FIG. 10B, the first openings 18a and the second opening 18b are made in the insulating film 18 by, for example, wet etching using a resist mask. The first openings 18a reach the p-side electrode 16; and the second opening 18b reaches the n-side electrode 17.

Then, as shown in FIG. 10B, the foundation metal film 60 is formed on the surface of the insulating film 18, the inner walls (the side walls and bottom surfaces) of the first openings 18a, and the inner walls (the side wall and bottom surface) of the second opening 18b. As shown in FIG. 11A, the foundation metal film 60 includes the aluminum film 61, the titanium film 62, and the copper film 63. The foundation metal film 60 is formed by, for example, sputtering.

Continuing, the p-side interconnect layer 21, the n-side interconnect layer 22, and the metal film 51 are formed by copper electroplating using the copper film 63 of the foundation metal film 60 as a seed layer after selectively forming a resist mask 91 shown in FIG. 11B on the foundation metal film 60.

The p-side interconnect layer 21 also is formed inside the first openings 18a and is electrically connected to the p-side electrode 16. The n-side interconnect layer 22 also is formed inside the second opening 18b and is electrically connected to the n-side electrode 17.

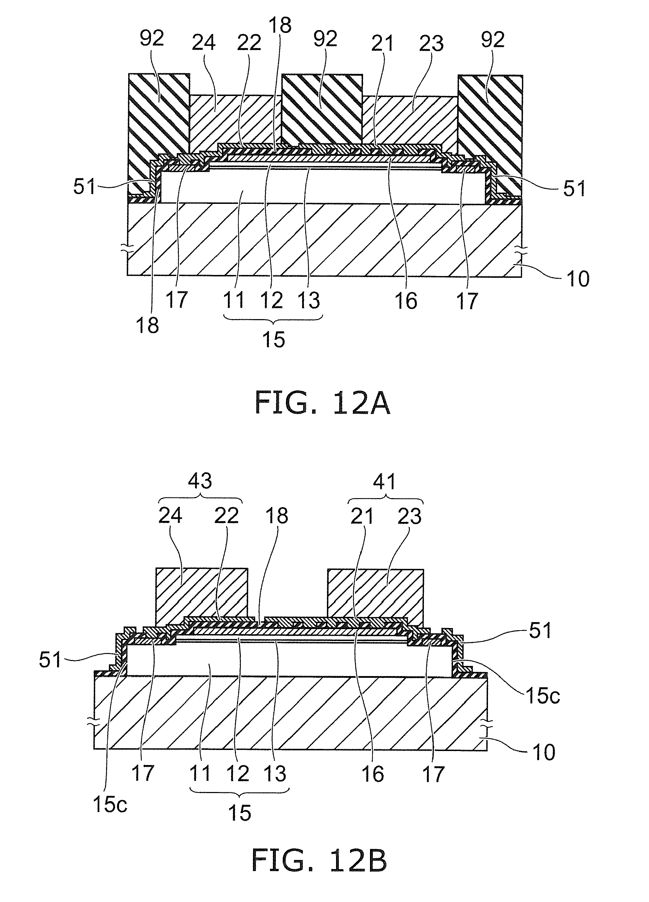

Then, after removing the resist mask 91 using, for example, a solvent or oxygen plasma, a resist mask 92 shown in FIG. 12A is selectively formed. Or, the resist mask 92 may be formed without removing the resist mask 91.

After forming the resist mask 92, the p-type metal pillar 23 and the n-side metal pillar 24 are formed by copper electroplating using the p-side interconnect layer 21 and the n-side interconnect layer 22 as a seed layer.

The p-type metal pillar 23 is formed on the p-side interconnect layer 21. The p-side interconnect layer 21 and the p-type metal pillar 23 are formed in a single body made of the same copper material. The n-side metal pillar 24 is formed on the n-side interconnect layer 22. The n-side interconnect layer 22 and the n-side metal pillar 24 are formed in a single body made of the same copper material.

The resist mask 92 is removed using, for example, a solvent or oxygen plasma. At this point in time, the p-side interconnect layer 21 and the n-side interconnect layer 22 are linked to each other via the foundation metal film 60. Also, the p-side interconnect layer 21 and the metal film 51 are linked to each other via the foundation metal film 60; and the n-side interconnect layer 22 and the metal film 51 are linked to each other via the foundation metal film 60.

Therefore, the foundation metal film 60 that is between the p-side interconnect layer 21 and the n-side interconnect layer 22, the foundation metal film 60 that is between the p-side interconnect layer 21 and the metal film 51, and the foundation metal film 60 that is between the n-side interconnect layer 22 and the metal film 51 are removed by etching.

Thereby, as shown in FIG. 12B, the electrical connection between the p-side interconnect layer 21 and the n-side interconnect layer 22, the electrical connection between the p-side interconnect layer 21 and the metal film 51, and the electrical connection between the n-side interconnect layer 22 and the metal film 51 are broken.

The metal film 51 that is formed in the region around the side surface 15c of the semiconductor layer 15 is electrically floating, does not function as an electrode, and functions as a reflective film. The metal film 51 is ensured to function as the reflective film by including at least the aluminum film 61.

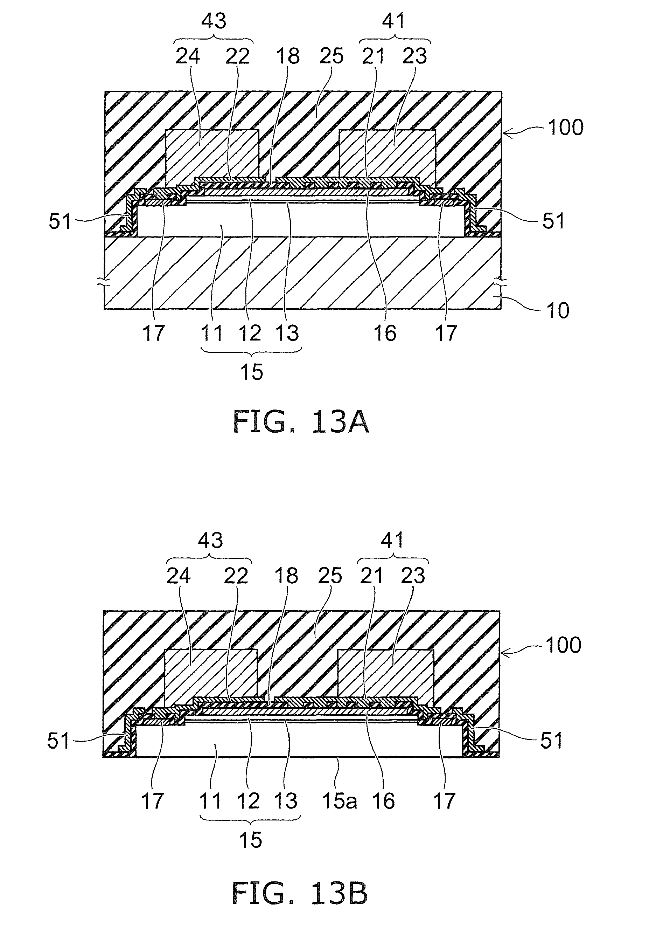

Then, the resin layer 25 shown in FIG. 13A is formed on the structural body shown in FIG. 12B. The resin layer 25 covers the p-side interconnect unit 41 and the n-side interconnect unit 43. Also, the resin layer 25 covers the metal film 51.

The resin layer 25 is included in the support body 100 with the p-side interconnect unit 41 and the n-side interconnect unit 43. The substrate 10 is removed in the state in which the semiconductor layer 15 is supported by the support body 100.

For example, the substrate 10 which is a silicon substrate is removed by wet etching or dry etching. Or, in the case where the substrate 10 is a sapphire substrate, the substrate 10 can be removed by laser lift-off.

There are cases where the semiconductor layer 15 that is epitaxially grown on the substrate 10 has a large internal stress. The p-type metal pillar 23, the n-side metal pillar 24, and the resin layer 25 are materials that are more flexible than the semiconductor layer 15 that is made of, for example, a GaN-based material. Accordingly, even in the case where the internal stress of the epitaxial growth is relieved all at once when peeling the substrate 10, the stress is absorbed by the p-type metal pillar 23, the n-side metal pillar 24, and the resin layer 25. Therefore, damage of the semiconductor layer 15 in the process of removing the substrate 10 can be avoided.

As shown in FIG. 13B, the first surface 15a of the semiconductor layer 15 is exposed by the removal of the substrate 10. A micro unevenness is formed in the first surface 15a that is exposed. For example, wet etching of the first surface 15a is performed using a KOH (potassium hydroxide) aqueous solution, TMAH (tetramethyl ammonium hydroxide), etc. Different etching rates that depend on the crystal plane orientation occur in the etching. Therefore, the unevenness can be formed in the first surface 15a. The extraction efficiency of the light radiated by the light emitting layer 13 can be increased by forming the micro unevenness in the first surface 15a.

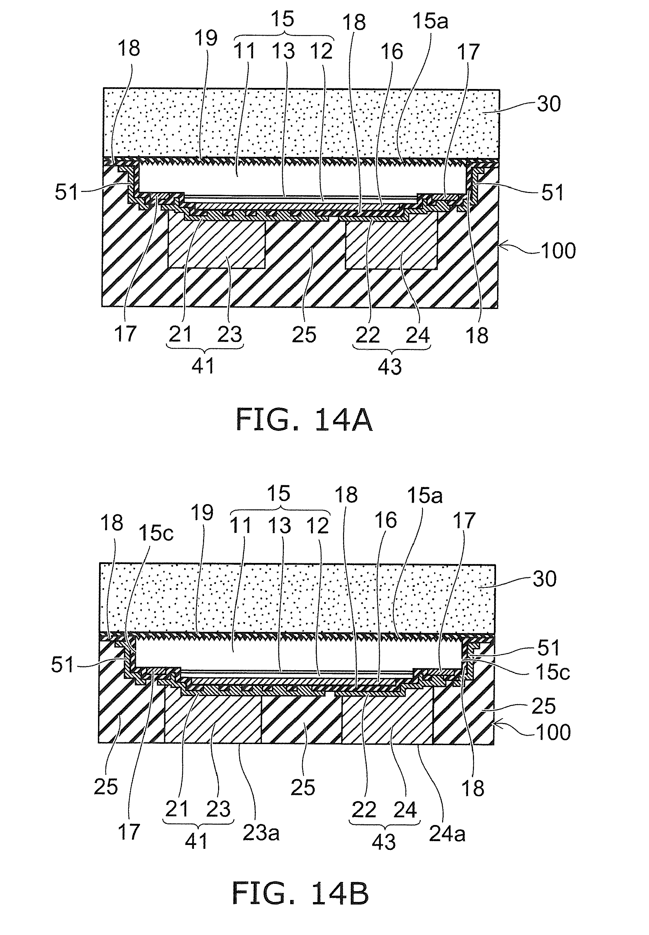

As shown in FIG. 14A, the fluorescer layer 30 is formed on the first surface 15a with the insulating film 19 interposed. The fluorescer layer 30 is formed by a method such as, for example, printing, potting, molding, compression molding, etc. The insulating film 19 increases the adhesion between the semiconductor layer 15 and the fluorescer layer 30.

As the fluorescer layer 30, a cured fluorescer that is made of fluorescers cured in a binder may be bonded to the semiconductor layer 15 with the insulating film 19 interposed.

The fluorescer layer 30 also is formed on the region around the side surface 15c of the semiconductor layer 15. The resin layer 25 is provided also in the region around the side surface 15c of the semiconductor layer 15. The fluorescer layer 30 is formed on the resin layer 25 with the insulating films 18 and 19 interposed.

The trench 35 and the unevenness described above are made in the upper surface of the fluorescer layer 30 in the wafer state prior to the dicing for the singulation into the multiple semiconductor light emitting devices.

After forming the fluorescer layer 30, the p-type metal pillar 23 and the n-side metal pillar 24 are exposed from the resin layer 25 as shown in FIG. 14B by polishing the surface of the resin layer 25 (in FIG. 14A, the lower surface). The exposed surface of the p-type metal pillar 23 is used as the p-side external terminal 23a; and the exposed surface of the n-side metal pillar 24 is used as the n-side external terminal 24a.

Then, dicing is performed in the region where the trench 90 described above is made to divide the multiple semiconductor layers 15. In other words, the fluorescer layer 30, the insulating film 19, the insulating film 18, and the resin layer 25 are cut. These components are cut by, for example, a dicing blade or laser light. The semiconductor layer 15 is not damaged by the dicing because the semiconductor layer 15 does not exist in the dicing region.

The processes described above prior to the singulation are performed in the wafer state that includes many semiconductor layers 15. The wafer is singulated into semiconductor light emitting devices including at least one semiconductor layer 15 each. The semiconductor light emitting device may have a single-chip structure including one semiconductor layer 15; or a multi-chip structure including multiple semiconductor layers 15 may be used.

Because the processes described above prior to the singulation can be performed collectively in the wafer state, it is unnecessary to perform the formation of the interconnect layers, the formation of the pillars, the packaging with the resin layer, and the formation of the fluorescer layer for every singulated individual device; and a drastic cost reduction is possible.

The side surface 30b of the fluorescer layer 30 can be tilted at an obtuse angle with respect to the first surface 15a as shown in FIG. 1, etc., by, for example, dicing the wafer using a blade of which the side surface at the tip is tilted.

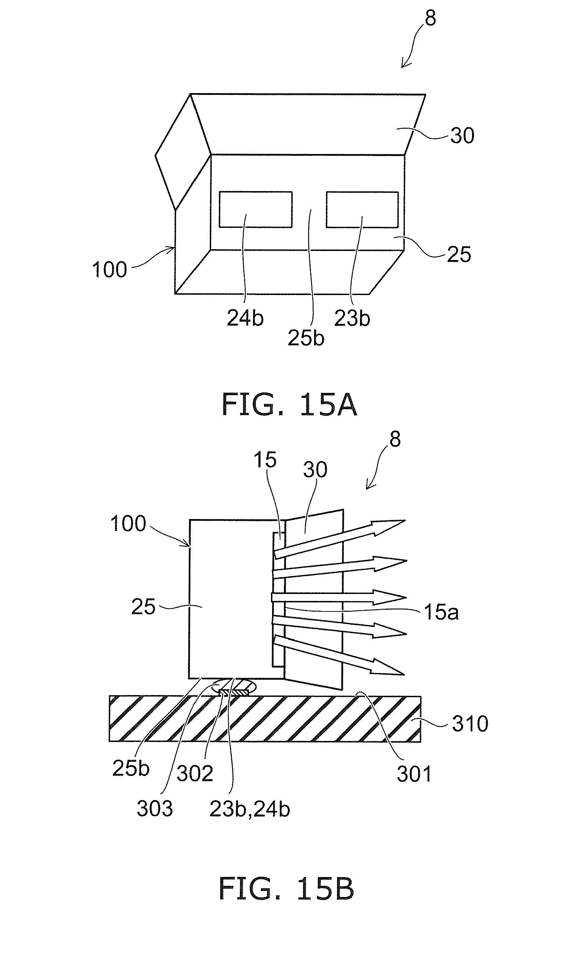

The embodiments described above also are applicable to a side-view type semiconductor light emitting device 8 shown in FIGS. 15A and 15B.

In the semiconductor light emitting device 8 of the eighth embodiment shown in FIGS. 15A and 15B, the exposed surfaces of the metal pillars 23 and 24 that are exposed from the resin layer 25 to provide the connection to the outside differ from those of the embodiment recited above; but otherwise, the configuration is the same as those of the embodiments recited above.

FIG. 15A is a schematic perspective view of the semiconductor light emitting device 8.

FIG. 15B is a schematic cross-sectional view of a light emitting module having a configuration in which the semiconductor light emitting device 8 is mounted on a mounting substrate 310.

The side surface of a portion of the p-type metal pillar 23 is exposed from the resin layer 25 at a third surface 25b that has a plane orientation that is different from the first surface 15a of the semiconductor layer 15 and the second surface 15b of the semiconductor layer 15 on the side opposite to the first surface 15a. The exposed surface functions as a p-side external terminal 23b for mounting to the external mounting substrate 310.

For example, the third surface 25b is a surface substantially perpendicular to the first surface 15a and the second surface 15b of the semiconductor layer 15. The resin layer 25 has, for example, four side surfaces having rectangular configurations; and one of the side surfaces is the third surface 25b.

The side surface of a portion of the n-side metal pillar 24 is exposed from the resin layer 25 at the same third surface 25b. The exposed surface functions as an n-side external terminal 24b for mounting to the external mounting substrate 310.

The portion of the p-type metal pillar 23 other than the p-side external terminal 23b that is exposed at the third surface 25b is covered with the resin layer 25. The portion of the n-side metal pillar 24 other than the n-side external terminal 24b that is exposed at the third surface 25b is covered with the resin layer 25.

As shown in FIG. 15B, the semiconductor light emitting device 8 is mounted with an orientation in which the third surface 25b is oriented toward a mounting surface 301 of the substrate 310. The p-side external terminal 23b and the n-side external terminal 24b that are exposed at the third surface 25b are bonded via solder 303 respectively to pads 302 provided in the mounting surface 301. An interconnect pattern that provides a link to, for example, an external circuit is provided in the mounting surface 301 of the substrate 310; and the pads 302 are connected to the interconnect pattern.

The third surface 25b is substantially perpendicular to the first surface 15a which is the main emission surface of the light. Accordingly, the first surface 15a is oriented in a horizontal direction parallel to the mounting surface 301 or a direction tilted with respect to the mounting surface 301 with an orientation in which the third surface 25b is oriented toward the mounting surface 301 side. In other words, the side-view type semiconductor light emitting device emits the light in the horizontal direction parallel to the mounting surface 301 or a direction oblique to the mounting surface 301.

Although the fluorescer layer 30 of the first embodiment is shown in FIGS. 15A and 15B, the fluorescer layer 30 of one selected from FIG. 1, FIG. 2, FIG. 3, FIG. 4, FIG. 5A, and FIG. 5B is applicable as the fluorescer layer 30 of the side-view type semiconductor light emitting device 8.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modification as would fall within the scope and spirit of the inventions.

## Claims

1. A semiconductor light emitting device, comprising:
a semiconductor layer (15) including a light emitting layer (13), the semiconductor layer (15) having a first surface (15a) and a second surface (15b) opposite to the first surface (15a);
a p-side electrode (16) provided on the semiconductor layer (15);
an n-side electrode (17) provided on the semiconductor layer (15);
a p-side interconnect unit (41) provided on the second surface side to be connected to the p-side electrode (16);
an n-side interconnect unit (43) provided on the second surface side to be connected to the n-side electrode (17);
a resin layer (25) provided between the p-side interconnect unit (41) and the n-side interconnect unit (43); and
a fluorescer layer (30) provided on the first surface (15a) side, the fluorescer layer (30) having a side surface (30b) provided at an obtuse angle with respect to the first surface (15a), the fluorescer layer (30) including a plurality of fluorescers (31) and a binder (32), the plurality of fluorescers (31) being configured to be excited by light emitted from the light emitting layer (13) to emit light of a wavelength different from a wavelength of the light emitted from the light emitting layer (13), the binder (32) being configured to combine the plurality of fluorescers (31) in a single body and transmit the light emitted from the light emitting layer (13) and light emitted from the fluorescers (31).

2. The device according to claim 1, wherein the side surface (30b) of the fluorescer layer (30) is flatter than an upper surface (30a) of the fluorescer layer (30).

3. The device according to claim 1 or 2, wherein a trench (35) is made in a line configuration in an upper surface (30a) of the fluorescer layer (30), the trench (35) having a side surface (36) tilted with respect to the upper surface (30a).

4. The device according to claim 3, wherein a cross-sectional configuration of the trench (35) is a V-shaped configuration.

5. The device according to claim 3 or 4, wherein a depth of the trench (35) is greater than a size of the fluorescers (31).

6. A semiconductor light emitting device, comprising:
a semiconductor layer (15) including a light emitting layer (13), the semiconductor layer (15) having a first surface (15a) and a second surface (15b) opposite to the first surface (15a);
a p-side electrode (16) provided on the semiconductor layer (15);
an n-side electrode (17) provided on the semiconductor layer (15);
a p-side interconnect unit (41) provided on the second surface side to be connected to the p-side electrode (16);
an n-side interconnect unit (43) provided on the second surface side to be connected to the n-side electrode (17);
a resin layer (25) provided between the p-side interconnect unit (41) and the n-side interconnect unit (43); and
a fluorescer layer (30) provided on the first surface (15a) side, the fluorescer layer (30) including a plurality of fluorescers (31) and a binder (32), the plurality of fluorescers (31) being configured to be excited by light emitted from the light emitting layer (13) to emit light of a wavelength different from a wavelength of the light emitted from the light emitting layer (13), the binder (32) being configured to combine the plurality of fluorescers (31) in a single body and transmit the light emitted from the light emitting layer (13) and light radiated by the fluorescers (31),
a trench (35) being made in a line configuration in an upper surface (30a) of the fluorescer layer (30), the trench (35) having a side surface (36) tilted with respect to the upper surface (30a).

7. The device according to claim 6, wherein a cross-sectional configuration of the trench (35) is a V-shaped configuration.

8. The device according to claim 6 or 7, wherein a depth of the trench (35) is greater than a size of the fluorescers (31).

9. The device according to any of claims 6-8, wherein an unevenness is formed in a region of the upper surface (30a) of the fluorescer layer (30) other than the region of the upper surface (30a) of the fluorescer layer (30) where the trench (35) is made.

10. The device according to any of claims 1-9, wherein
the p-side interconnect unit (41) includes a p-side interconnect layer (21) and a p-type metal pillar (23), the p-side interconnect layer (21) being connected to the p-side electrode (16), the p-type metal pillar (23) being connected to the p-side interconnect layer (21) and thicker than the p-side interconnect layer (21), and
the n-side interconnect unit (43) includes an n-side interconnect layer (22) and an n-side metal pillar (24), the n-side interconnect layer (22) being connected to the n-side electrode (17), the n-side metal pillar (24) being connected to the n-side interconnect layer (22) and thicker than the n-side interconnect layer (22).

11. The device according to claim 10, wherein an end portion (23a) of the p-type metal pillar (23) and an end portion (24a) of the n-side metal pillar (24) are externally connectable and arranged in the same surface.

12. The device according to any of claims 1-11, wherein
the semiconductor layer (15) does not include a substrate on the first surface (15a) side, and
the fluorescer layer (30) is provided on the first surface (15a) side without a substrate being interposed between the fluorescer layer (30) and the semiconductor layer (15).

13. The device according to any of claims 1-12, further comprising a metal film (51) covering a side surface (15c) of the semiconductor layer (15) continuing from the first surface (15a).

14. The device according to any of claims 1-13, wherein the resin layer (25) is light-shielding to the light emitted from the light emitting layer (13).

15. The device according to claim 1, wherein the side surface (30b) of the fluorescer layer (30) is positioned outside a side surface of a support body (100) including the p-side interconnect unit (41), the n-side interconnect unit (43), and the resin layer (25).
